Europäisches Patentamt

European Patent Office

Office européen des brevets

(19)

(11) Numéro de publication: **0 283 074 B1**

(12) **FASCICULE DE BREVET EUROPEEN**

(45) Date de publication de fascicule du brevet:
27.11.91

(51) Int. Cl.5: **H03D 9/06**

(21) Numéro de dépôt: **88200370.0**

(22) Date de dépôt: **29.02.88**

(54) **Mélangeur hyperfréquences.**

(30) Priorité: **06.03.87 FR 8703084**

(43) Date de publication de la demande:
**21.09.88 Bulletin 88/38**

(45) Mention de la délivrance du brevet:
**27.11.91 Bulletin 91/48**

(84) Etats contractants désignés:
**DE FR GB IT**

(56) Documents cités:
**EP-A- 0 057 480**
**EP-A- 0 087 841**
**US-A- 4 592 095**

**IEEE TRANSACTIONS ON MICROWAVE THEORY AND TECHNIQUES, vol. MTT-32, no. 3, mars 1984, pages 248-255, IEEE, New York, US; C. TSIRONIS et al.: "Dual-gate MESFET mixers"**

**PROCEEDINGS OF THE 6th EUROPEAN MI-CROWAVE CONFERENCE, Rome, 14-17 septembre 1976, pages 8-13, Microwave Exhibitions and Publishers Ltd, Sevenoaks, Kent, GB; P. HARROP et al.: "Performance of some GaAs MESFET mixers"**

(73) Titulaire: **LABORATOIRES D'ELECTRONIQUE PHILIPS**
**3, Avenue Descartes**
**F-94450 Limeil-Brévannes(FR)**

(84) Etats contractants désignés:
**FR**

Titulaire: **N.V. Philips' Gloeilampenfabrieken**
**Groenewoudseweg 1**
**NL-5621 BA Eindhoven(NL)**

(84) Etats contractants désignés:
**DE GB IT**

(72) Inventeur: **Pyndiah, Ramesh Société Civile S.P.I.D.**
**209, rue de l'Université**
**F-75007 Paris(FR)**
Inventeur: **Gamand, Patrice Société Civile S.P.I.D.**
**209, rue de l'Université**
**F-75007 Paris(FR)**

Rank Xerox (UK) Business Services

(74) Mandataire: **Jacquard, Philippe et al
Société Civile S.P.I.D. 156, Boulevard Haussmann
F-75008 Paris(FR)**

## Description

La présente invention a pour objet un mélangeur hyperfréquences présentant un premier et un deuxième transistor à effet de champ, l'un des transistors étant destiné à recevoir sur sa grille un signal d'oscillateur local et l'autre un signal d'entrée radio-fréquence, le premier transistor ayant une source connectée à un premier pôle de tension d'alimentation, et un drain relié en un point commun à une source du deuxième transistor, et le drain du deuxième transistor étant relié à un deuxième pôle de tension d'alimentation à travers une résistance.

Un tel mélangeur a été décrit dans l'article publié par Peter HARROP et collaborateurs dans la publication "Proceedings of the Sixth European Microwave Conference" Rome 14-17 september 1976 p. 8-13.

Ce mélangeur a été conçu pour un fonctionnement dans la gamme 7-9 GHz environ.

La demanderesse a constaté que, l'entrée sur la grille du deuxième transistor devenait d'autant plus instable que la fréquence de coupure $f_T$ du transistor était plus élevée.

La demanderesse a pu identifier que cette instabilité était dûe à d'une part la capacité drain-source des deux transistors, et d'autre part à l'influence de la fréquence de coupure $f_T$ des transistors, leur capacité grille-drain n'ayant pas d'influence déterminante sur cette instabilité.

L'invention propose de réaliser une compensation permettant de maîtriser cette instabilité.

Le mélangeur selon l'invention est dans ce but caractérisé en ce que le drain du deuxième transistor est chargé par un élément de circuit réalisant un court-circuit à la fréquence du signal d'oscillateur local et en ce qu'il comporte un élément selfique disposé entre ledit point commun et un pôle de mode commun, la valeur de l'élément selfique étant choisie de manière à compenser les capacités drain-source des transistors et donc à éliminer l'instabilité de l'entrée sur la grille du deuxième transistor.

Selon un mode de réalisation avantageux le premier transistor est destiné à recevoir sur sa grille le signal radiofréquence, et le deuxième transistor est destiné à recevoir sur sa grille le signal d'oscillateur local.

Les grilles du premier et/ou du deuxième transistor peuvent comporter en entrée un circuit d'adaptation pour le signal radiofréquence et/ou le signal d'oscillateur local.

L'invention sera mieux comprise à la lecture de la description qui va suivre donnée à titre d'exemple non limitatif en liaison avec les dessins qui représentent :
- la figure 1 un mélangeur selon l'art antérieur,
- la figure 2 un mélangeur selon l'invention,
- la figure 3, un schéma équivalent illustrant le fonctionnement du circuit de la figure 1, avec en pointillés la self L disposée selon l'invention (figure 2)
- la figure 4 un mode de réalisation du mélangeur de la figure 2
- et les figures 5 et 6 une comparaison entre un circuit selon l'invention et un circuit analogue à l'art antérieur, au voisinage de 15 GHz et avec une fréquence intermédiaire de 200 Mhz, quant aux courbes de gain respectivement en fonction de la puissance d'oscillateur local et de la fréquence.

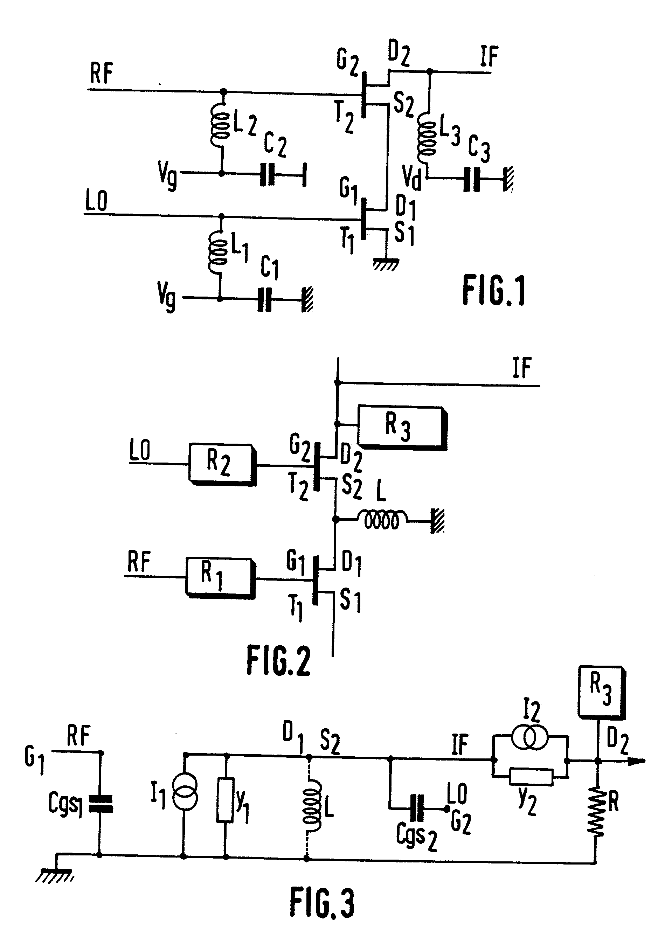

Selon la figure 1, un mélangeur décrit dans l'article précité comporte un transistor $T_1$ à effet de champ sur substrat AsGa, en l'occurence un transistor du type MESFET, présentant une source $S_1$ connectée au pôle de mode commun, une grille $G_1$ recevant un signal d'oscillateur local LO, et un drain $D_1$ connecté à la source $S_2$ d'un transistor $T_2$ à effet de champ sur substrat AsGa, en l'occurence également du type MESFET. Le transistor $T_2$ reçoit sur sa grille $G_2$ un signal radiofréquence RF et produit à sa sortie constituée par son drain $D_2$ un signal IF de fréquence intermédiaire.

Entre les grilles $G_1$ et $G_2$ et le pôle de mode commun sont montés deux réseaux d'alimentation comportant une self et un condensateur en série à savoir ($L_1$, $C_1$) pour le transistor $T_1$ et ($L_2$, $C_2$) pour le transistor $T_2$, le point commun aux deux éléments de chaque réseau recevant une tension de polarisation de grille Vg.

Enfin, entre le drain $D_2$ du transistor $T_2$ et le pôle de mode commun, est monté un réseau d'alimentation comportant en série une self $L_3$ et un condensateur $C_3$. Le point commun à la self $L_3$ et au condensateur $C_3$ est polarisé par une tension de polarisation de drain Vd.

Un tel circuit a été conçu avec des transistors présentant une grille de longueur 0,8 micron environ.

Au cas où on veut réaliser un mélangeur fonctionnant plus haut en fréquence, et mettant en oeuvre dans ce but des transistors dont la fréquence de coupure intrinsèque est beaucoup plus élevée que dans le cas précédent, la demanderesse a constaté qu'apparaissait une instabilité sur la grille $G_2$. Cette instabilité peut être compensée en désadaptant l'entrée de la grille $G_2$, mais au prix d'une augmentation importante de la puissance du signal injecté sur cette grille ; une puissance d'environ 20 mV environ s'avère alors nécessaire pour maintenir un facteur de gain correct entre le signal de fréquence intermédiaire FI de sortie et le signal radiofréquence RF d'entrée.

Selon la figure 2, le transistor $T_1$ reçoit le signal radiofréquence RF à travers un réseau d'adaptation $R_1$ et le transistor $T_2$, le signal d'oscillateur local LO à travers un réseau d'adaptation $R_2$, ces réseaux incluant les alimentations. Comme le montre l'article de Christos TSIRONIS et collaborateurs paru dans IEEE Transactions on microwave Theory and Thechniques Vol MTT 32 n°3 mars 1984 pp.248-255, ce mode d'attaque est plus avantageux car les non-linéarités interviennent essentiellement dans le transistor à effet de champ $T_2$ (transconductance $gm_2$ et résistance de canal $Rd_2$) et le transistor à effet de champ $T_1$ ne fait qu'amplifier le signal de radiofréquence.

Les hautes fréquences (LO, RF) sont court-circuitées par un réseau élémentaire $R_3$ qui peut être par exemple une ligne de métallisation ouverte de longueur $\lambda/4$ ($\lambda$ désignant la longueur d'onde correspondant à la fréquence d'oscillateur local) ou bien encore un condensateur de faible valeur (environ 1pF) de type interdigité en résonance série à la fréquence d'oscillateur local (voir l'article de Christios TSIRONIS et collaborateurs p 249 II)

Selon l'invention, on stabilise l'entrée sur la grille $G_2$ du transistor $T_2$ en disposant un élément selfique L de valeurs convenablement choisie entre le point d'interconnexion du drain $D_1$ du transistor $T_1$ et de la source $S_2$ du transistor $T_2$, et le pôle de mode commun.

Le circuit de la figure 2 peut être modélisé en première approximation par le circuit de la figure 3. Les transistors $T_1$ ($T_2$) sont modélisés par les condensateurs $CgS_1$ ($CgS_2$), les sources de courant commandées en tension $l_1$ ($l_2$) et les impédances de sortie $y_1$ ($y_2$). Le drain du deuxième transistor $T_2$ est chargé par une ligne $R_3$ en circuit ouvert qui ramène un court-circuit à la fréquence d'oscillateur local LO et par une résistance R reliée au pôle de mode commun. Le signal radiofréquence RF injecté sur la capacité $CgS_1$ est amplifié par le premier transistor $T_1$ et injecté sur la source du deuxième transistor $T_2$ où les non-linéarités dûes au fort signal d'oscillateur local LO injecté sur la capacité $Cgs_2$ du deuxième transistor $T_2$ génèrent le signal de fréquence intermédiaire $F_I$ qui est prélevé sur le drain du deuxième transistor $T_2$.

On a :

$$y_1 = gd_1 + j\omega\, Cds_1$$

$$y_2 = gd_2 + j\omega\, Cds_2$$

avec

$gd_1$ , $gd_2$ = conductance drain-source respectivement des transistors $T_1$ et $T_2$.

$CdS_1$, $CdS_2$ : capacité drain-source respectivement des transistor $T_1$ et $T_2$.

A la fréquence d'oscillateur local LO, l'impédance d'entrée $Z_i$ de la grille $G_2$ du transistor $T_2$ peut alors s'écrire (en faisant abstraction de l'élément selfique L) :

$$Zi = \frac{gd_1 + gd_2 - gm_2\,(Cds_1 + Cds_2)/Cgs_2}{(gd_1 + gd_2)^2 + \omega^2\,(Cds_1 + Cds_2)^2}$$

$$-j\,\frac{[(Cds_1 + Cds_2)\,\omega + (gd_1 + gd_2)gm2/\omega Cgs_2]}{(gd_1 + gd_2)^2 + \omega^2\,(Cds_1 + Cds_2)^2} + \frac{1}{j\omega Cgs_2}$$

avec

$gm_2$ = transconductivité du transistor $T_2$

$Cgs_2$ = capacité grille-source du transistor $T_2$

L'instabilité est dûe au fait que le terme réel se retrouve avoir une valeur négative lorsqu'on met en oeuvre des transistors ayant une fréquence de coupure $f_T$ élevée.

En effet, la fréquence de coupure $fT_2$ du transistor $T_2$, qui est définie comme la fréquence à laquelle son gain est de 0 dB, a pour valeur :

$$fT_2 = \frac{gm_2}{2\pi Cgs_2}$$

L'instabilité se produit quand :

$$A = gd_1 + gd_2 - gm_2(Cds_1 + Cds_2)/Cgs_2 < 0$$

ou

$$A = gd_1 + gd_2 - 2\pi fT_2 (Cds_1 + Cds_2) < 0$$

L'instabilité est d'autant plus importante que la fréquence de coupure $fT_2$ du transistor $T_2$ est élevée.

Une solution pour remédier à cette instabilité consiste à désadapter l'entrée $G_2$ du transistor $T_2$ et à introduire une résistance qui permet de rendre positif le terme résistif de l'impédance d'entrée $Zi$. Cette solution a pour inconvénient d'augmenter considérablement la puissance nécessaire du signal d'oscillateur local LO.

Selon l'invention, on dispose l'élément selfique L entre le drain $D_1$ interconnecté avec la source $S_2$, et le pôle de mode commun.

L'expression de l'impédance d'entrée $Zi$ devient alors (toujours à la fréquence d'oscillateur local OL) :

$$Z'i = \frac{1}{D} \left[ gd_1 + gd_2 - 2\pi fT_2 \left(Cds_1 + Cds_2 - \frac{1}{\omega^2 L}\right) \right]$$

$$- \frac{j}{D} \left[ \omega(Cds_1 + Cds_2 - \frac{1}{\omega^2 L}) + (gd_1 + gd_2)\frac{\omega T}{\omega} \right] + \frac{1}{j\omega Cgs_2}$$

avec $\omega T = 2\pi fT$

et $D = (gd_1 + gd_2)^2 + \omega^2 (Cds_1 + Cds_2 - \frac{1}{\omega^2 L})^2$

L'instabilité sera compensée lorsque :

$$A' = gd_1 + gd_2 - 2\pi fT_2 (Cds_1 + Cds_2 - \frac{1}{\omega^2 L}) > 0$$

soit :

$$L < \frac{1}{\omega o^2} \frac{2\pi fT_2}{2\pi fT_2 \, Cds - gd}$$

avec

$Cds = Cds_1 + Cds_2$

$gd = gd_1 + gd_2$

$\omega_0 = 2\pi Fo$

$Fo$ = fréquence d'oscillateur local LO la plus haute

L'instabilité ainsi compensée, il est possible d'adapter l'entrée sur la grille de $G_2$ et donc de commander le mélangeur avec une puissance minimale.

La mise en oeuvre de l'élément selfique L peut également permettre d'obtenir d'autres avantages.

Tout d'abord la présence de cette self a pour conséquence que le point milieu du montage $(D_1, S_2)$ est ramené au pôle de mode commun en continu, ce qui permet de polariser indépendamment les transistors $T_1$ et $T_2$.

Ensuite, la self L a pour effet de court-circuiter les bruits à la fréquence intermédiaire IF générée par le premier transistor $T_1$ du mélangeur, ce qui est particulièrement intéressant dans le cas des transistors hyperfréquences par exemple les MESFET.

Le bruit basse fréquence généré par le transistor $T_1$ est amplifié par le transistor $T_2$.

La valeur de la tension V sur le drain $D_1$ du premier transistor (source $S_2$ du transistor $T_2$) est donnée par la formule suivante :

$$V = \frac{RdIo}{1 + j\omega\ Cds\ Rd\ [\ 1 - (\frac{\omega_1}{\omega})^2\ ]}$$

avec $Rd = \frac{1}{gd}$

$$\omega_1 = \frac{1}{\sqrt{LCds}}$$

avec $I_0 = I_1$ = courant de bruit généré par le premier transistor $T_1$.

En d'autres termes, la self L permet de réaliser un filtre passe-bande dont la fréquence centrale est située au milieu de la bande utile de réception, de manière à filtrer le bruit situé dans la bande des fréquences intermédiaires et généré par le premier transistor $T_1$.

Enfin, la self L peut être choisie de manière à adapter la sortie sur le drain $D_1$ du transistor $T_1$ à l'entrée sur la source du transistor $T_2$.

La condition d'adaptation s'écrit :

$$\frac{1}{\omega^2_{RF}L} = Cds$$

$\omega_{RF} = 2\pi\ F_{RF}$, $F_{RF}$ désignant la fréquence reçue, et $F_{RF} \# F_{LO}$.

Dans ce cas, $A' = gd > 0$ .

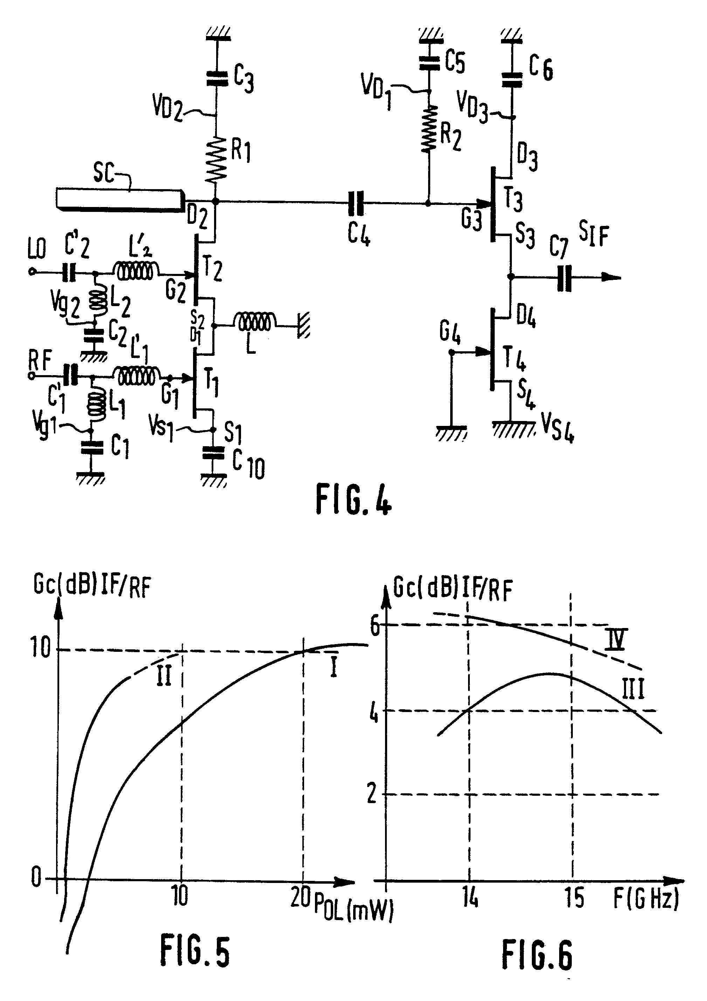

Selon la figure 4, le mélangeur comporte deux étages, un premier étage réalisant la fonction mélangeuse proprement dite et un deuxième étage formant tampon.

La source $S_1$ du transistor $T_1$ est reliée au pôle de mode commun à travers un condensateur de découplage $C_{10}$, la source $S_1$ étant alimentée par une source de tension négative $V_{S1}$ et le drain $D_2$ du transistor $T_2$ au pôle de mode commun à travers deux éléments en série, à savoir une résistance $R_1$ et un condensateur $C_3$ de découplage, le point commun à ces deux éléments étant alimenté par une tension de polarisation drain-source $V_{D2}$.

Les entrées des signaux radio-fréquence RF et d'oscillateur local LO sont réalisées à travers des capacités de liaison hyperfréquence respectivement $C'_1$ et $C'_2$. Le réseau $R_1$ d'adaptation à l'entrée sur la grille $G_1$ comporte un élément selfique $L'_1$ en série avec la capacité $C'_1$ et connecté à la grille $G_1$, et entre d'une part le point commun à la capacité $C'_1$ et à l'élément selfique $L'_1$ et d'autre part le pôle de mode commun, il comporte un élément selfique $L_1$ et un condensateur de découplage hyperfréquences $C_1$. Le point commun à l'élément selfique $L_1$ et au condensateur $C_1$ reçoit une tension de polarisation de grille $Vg_1$. Le réseau $R_2$ d'adaptation à l'entrée sur la grille $G_2$ comporte un élément selfique $L'_2$ en série avec une capacité $C'_2$ et connecté à la grille $G_2$, et entre d'une part le point commun à la capacité $C'_2$ et à l'élément selfique $L'_2$, et d'autre part le pôle de mode commun, il comporte un élément selfique $L_2$ et un condensateur $C_2$ de découplage hyperfréquences. Le point commun à l'élément selfique $L_2$ et au condensateur $C_2$ reçoit une tension de polarisation de grille $Vg_2$.

Le réseau figuré par une ligne de transmission SC de longueur $\lambda LO/4$ ($\lambda LO$ désignant la longueur d'onde de la fréquence d'oscillateur local dans le substrat).

Un condensateur $C_4$ de liaison à la fréquence intermédiaire FI est disposé entre le drain $D_2$ du transistor $T_2$ et la grille $G_3$ d'un transistor $T_3$ à effet de champ. La grille $G_3$ est polarisée par une tension $Vg_3$ appliquée à la borne commune à un condensateur $C_5$ de découplage de la fréquence intermédiaire et à une résistance $R_2$. L'autre borne du condensateur $C_5$ est connectée au pôle de mode commun et l'autre borne de la résistance $R_2$, à la grille $G_3$. Le drain $D_3$ du transistor $T_3$ reçoit une tension de polarisation de drain $V_{D3}$ et est relié au pôle de mode commun à travers un condensateur $C_6$ de découplage de la

EP 0 283 074 B1

fréquence intermédiaire. La source $S_3$ du transistor $T_3$ est connectée au drain $D_4$ d'un transistor $T_4$ dont la source $S_4$ est connectée au pôle de mode commun et dont la grille $G_4$ est connectée au pôle de mode commun.

Le signal de fréquence intermédiaire $S_{IF}$ est obtenu au point commun à $S_3$ et $D_4$ après passage à travers un condensateur de liaison de fréquence intermédiaire IF.

Les figures 5 et 6 représentent les résultats qui peuvent être obtenus avec le mélangeur de la figure 4 en comparaison avec les montages ne présentant pas l'élément selfique $L_1$ et pour lesquels on est contraint de désadapter l'entrée sur la grille $G_2$ en supprimant l'élément selfique $L'_2$ et en remplaçant l'élément selfique $L_2$ par une résistance.

La figure 5 représente le gain exprimé en dB en fonction de la puissance P du signal d'oscillateur local, pour une valeur de la fréquence intermédiaire $f_{IF}$ de 200 MHz et une fréquence d'oscillateur local $f_{LO}$ de 15 GHz. La courbe I correspond à l'art antérieur et la courbe II au circuit de la figure 4. La désadaptation nécessaire de l'entrée sur la grille $G_2$ impose une puissance du signal d'oscillateur beaucoup plus élevée dans les circuits de l'art antérieur.

La figure 6 représente le gain exprimé en dB en fonction de la fréquence, la courbe III correspondant a une puissance $P_{LO}$ du signal d'oscillateur local LO de 5,5 mW (7,5 dBm) pour un circuit de l'art antérieur, et la courbe IV à une puissance $P_{LO}$ de 1,6 mW (2dBm) pour le circuit de la figure 4, avec dans les deux cas une fréquence intermédiaire $f_{IF}$ de 200 MHz. La courbe IV, bien que correspondant à une puissance injectée par l'oscillateur local qui est plus de deux fois inférieure, correspond à des gains supérieurs à ceux de la courbe III.

L'invention ne se limite pas aux modes de réalisation décrits et représentés. Par exemple les éléments selfiques peuvent être réalisés de différentes manières ; inductance ou ligne de transmission connue sous la dénomination angle-saxonne de microstrips ou de coplanar lines.

Un mélangeur selon l'invention peut être intégré sur substrat $Al_2O_3$ et monolithiquement intégré sur substrat GaAs.

**Revendications**

1. Mélangeur hyperfréquences présentant un premier et un deuxième transistor à effet de champ, l'un des transistors étant destiné à recevoir sur sa grille un signal d'oscillateur local et l'autre un signal d'entrée radio-fréquence, le premier transistor (T1) ayant une source connectée à un premier pôle de tension d'alimentation, et un drain relié en un point commun à une source du deuxième transistor (T2), et le drain du deuxième transistor étant relié à un deuxième pôle de tension d'alimentation à travers une résistance, caractérisé en ce que le drain du deuxième transistor (T2) est chargé par un élément de circuit (R3) réalisant un court-circuit à la fréquence du signal d'oscillateur local, et un élément selfique (L) est disposé entre ledit point commun et un pôle de mode commun, l'élément selfique étant choisi de manière à compenser les capacités drain-source des deux transistors et donc à stabiliser l'entrée sur la grille du deuxième transistor (T2).

2. Mélangeur selon la revendication 1, caractérisé en ce que le premier transistor (T1) est destiné à recevoir sur sa grille le signal radiofréquence (RF) et le deuxième transistor est destiné à recevoir sur sa grille le signal d'oscillateur local (LO).

3. Mélangeur selon une des revendications 1 ou 2 caractérisé en ce que la grille du premier transistor (T1) comporte un circuit d'adaptation (R1) au signal qu'elle est destinée à recevoir.

4. Mélangeur selon une des revendications 1 à 3 caractérisé en ce que la grille du deuxième transistor (T2) comporte un circuit d'adaptation (R2) au signal qu'elle est destinée à recevoir.

5. Mélangeur selon une des revendications précédentes caractérisé en ce que l'élément selfique a une valeur L telle que :

$$L < \frac{2\pi f_{T_2}}{2\pi f_{T_2} Cds - gd} \qquad \frac{1}{\omega o^2}$$

avec : $F_{T_2}$ fréquence de coupure à 0 dB du deuxième transistor

7

$Cgs_2$ capacité grille source du deuxième transistor

$Cds_1$ et $Cds_2$ capacités drain-source respectivement du premier et du deuxième transistor.

$gd_1$ et $gd_2$ conductance respectivement du premier et du deuxième transistor.

et $Cds = Cds_1 + Cds_2$, $gd = gd_1 + gd_2$

$\omega_o = 2\pi F_o$ $F_o$ = fréquence de l'oscillateur local la plus haute.

6. Mélangeur selon la revendication 5, caractérisé en ce que l'élément selfique L est choisi de manière à réaliser un filtre passe-bande dont la fréquence centrale est située sensiblement au milieu de la bande utile de réception, de manière à filtrer le bruit situé dans la bande des fréquences intermédiaires et généré par le premier transistor $T_1$.

7. Mélangeur selon l'une des revendications 5 ou 6 caractérisé en ce que l'élément selfique a une valeur L voisine de Lo avec :

$$L_O = \frac{1}{Cds\ \omega^2_{LO}}$$

avec $\omega_{LO} = 2\pi F_{LO}$, $F_{LO}$ désignant la fréquence d'oscillateur local.

## Claims

1. Very high frequency mixer comprising a first and a second field effect transistor, one of the transistors being intended to receive at its gate a local oscillator signal and the other transistor a radio-frequency input signal, the first transistor ($T_1$) having a source connected to a first supply voltage pole, and a drain connected at a junction point to a source of the second transistor ($T_2$), and the drain of the second transistor being connected to a second supply voltage pole via a resistor, characterized in that the drain of the second transistor ($T_2$) is charged by a circuit element ($R_3$) realizing a short-circuit at the frequency of the local oscillator signal, and in that the mixer comprises an inductor element (L) inserted between said junction point and a common-mode pole, the value of the inductor element being selected such as to compensate for the drain-source capacitances of the transistors and thus to stabilize the input at the gate of the second transistor ($T_2$).

2. Mixer as claimed in Claim 1, characterized in that the first transistor ($T_1$) is intended to receive at its gate the radio-frequency signal (RF), and the second transistor is intended to receive at its gate the local oscillator signal (LO).

3. Mixer as claimed in one of the Claims 1 or 2, characterized in that the gate of the first transistor ($T_1$) includes a matching circuit ($R_1$) for matching the signal which it is intended to receive.

4. Mixer as claimed in one of the Claims 1 to 3, characterized in that the gate of the second transistor ($T_2$) comprises a matching circuit ($R_2$) for the signal which it is intended to receive.

5. Mixer as claimed in one of the preceding Claims, characterized in that the inductor element has a value L such that:

$$L \leq \frac{1}{\omega O^2} \quad \frac{2\pi\ fT_2}{2\pi fT_2\ Cds\ -\ gd}$$

where:

$FT_2$ is the cut-off frequency at 0 dB of the second transistor,

$Cgs_2$ is the gate-source capacitance of the second transistor,

$Cds_1$ and $Cds_2$ are drain-source capacitances of the first and second transistors respectively,

$gd_1$ and $gd_2$ are conductances of the first and second transistors respectively, and

$Cds = Cds_1 + Cds_2$, $gd = gd_1 + gd_2$

$\omega_0 = 2\pi F_0$ $F_0$ = the highest local oscillator frequency.

6. Mixer as claimed in Claim 5, characterized in that the inductor element L is chosen such as to realize a bandpass filter whose central frequency is situated substantially within the useful receive band, so as to filter out the noise situated in the intermediatefrequency band and produced by the first transistor $T_1$.

7. Mixer as claimed in one of the Claims 5 or 6, characterized in that the inductor element has a value L around Lo with:

$$L_0 = \frac{1}{Cds\ \omega^2 L0}$$

with $\omega_{LO} = 2\pi F_{LO}$, $F_{LO}$ denoting the local oscillator frequency.

**Patentansprüche**

1. Höchstfrequenz-Mischstufe mit einem ersten und einem zweiten Feldeffekttransistor, von denen einer dazu bestimmt ist, an der Gate-Elektrode ein Ortsoszillatorsignal zu empfangen und der andere ein HF-Eingangssignal, wobei von dem ersten Transistor (T1) eine Source mit einem ersten Speisespannungspol verbunden ist, die Drain an einem gemeinsamen Punkt mit einer Source des zweiten Transistors (T2) liegt, und die Drain des zweiten Transistors über einen Widerstand mit einem zweiten Speisespannungspol verbunden ist, dadurch gekennzeichnet, daß die Drain des zweiten Transistors (T2) über ein bei der Frequenz des Ortsoszillatorsignals einen Kurzschluß bildendes Schaltungselement (R3) aufgeladen wird, und daß eine Induktivität (L) zwischen dem gemeinsamen Punkt und einem Gleichtaktpol vorgesehen ist, wobei die Induktivität derart gewählt ist, daß die Drain-Source-Kapazitäten der beiden Transistoren ausgeglichen werden und daß folglich das Eingangssignal an der Gate-Elektrode des zweiten Transistors (T2) stabilisiert wird.

2. Mischstufe nach Anspruch 1, dadurch gekennzeichnet, daß der erste Transistor (T1) dazu bestimmt ist, an der Gate-Elektrode das HF-Signal (RF) zu empfangen und der zweite Transistor dazu bestimmt ist, an der Gate-Elektrode das Ortsoszillatorsignal (LO) zu empfangen.

3. Mischstufe nach Anspruch 1 oder 2, dadurch gekennzeichnet, daß die Gate-Elektrode des ersten Transistors (T1) eine Schaltungsanordnung (R1) aufweist zum Anpassen derselben an das zu empfangende Signal.

4. Mischstufe nach einem der Ansprüche 1 bis 3, dadurch gekennzeichnet, daß die Gate-Elektrode des zweiten Transistors (T2) eine Schaltungsanordnung (R2) aufweist zum Anpassen derselben an das zu empfangende Signal.

5. Mischstufe nach einem der vorstehenden Ansprüche, dadurch gekennzeichnet, daß die Induktivität einen derartigen Wert L hat, daß

$$L \leq \frac{2\Pi f_{T2}}{2\Pi f_{T2} Cds - gd} \quad \frac{1}{\omega o^2}$$

wobei:
$F_{T2}$ die Grenzfrequenz bei 0 dB des zweiten Transistors ist;
$Cgs_2$ die Gate-Source-Kapazität des zweiten Transistors ist;
$Cds_1$ und $Cds_2$ die Drain-Source-Kapazität des ersten bzw. zweiten Transistors ist;
$gd_1$ und $gd_2$ die Konduktivität des ersten bzw. zweiten Transistors ist; und
$Cds = Cds_1 + Cds_2$, $gd = gd_1 + gd_2$ ist;
$\omega_0 = 2\pi F_0$ $F_0$ = die höchste Ortsoszillatorfrequenz ist.

6. Mischstufe nach Anspruch 5, dadurch gekennzeichnet, daß die Induktivität L derart gewählt worden ist, daß sie ein Bandpaßfilter bildet, dessen Zentralfrequenz nahezu mitten im nützlichen Empfangsband liegt, so daß die in dem ZF-Band liegenden und vom ersten Transistor T1 erzeugten Rauschanteile herausgefiltert werden.

7. Mischstufe nach einem der Ansprüche 5 oder 6, dadurch gekennzeichnet, daß die Induktivität einen Wert L in der Nähe von $L_0$ hat, wobei gilt:

$$L_0 \;=\; \frac{1}{Cds \; \omega^2_{LO}}$$

wobei

$\omega_{LO} = 2\pi \, F_{LO}$ ist, wobei $F_{LO}$ die Ortsoszillatorfrequenz ist.

FIG.1

FIG.2

FIG.3

FIG.4

FIG.5

FIG.6